# EUROPÄISCHE PATENTSCHRIFT

(11) **EP 1 675 265 B1**
(45) Veröffentlichungstag und Bekanntmachung des Hinweises auf die Patenterteilung: **17.02.2010**
(21) Anmeldenummer: 05027445.5
(22) Anmeldetag: 15.12.2005
(51) Int. Cl.: H03K 17/96

(54) **Schaltungsanordnung für einen kapazitiven Berührungsschalter**
Circuit for a capacitive touch switch
Circuit pour un commutateur capacitif à effleurement

(30) Priorität: 22.12.2004 DE 102004061741; 14.01.2005 DE 102005001777
(43) Veröffentlichungstag der Anmeldung: 28.06.2006
(73) Patentinhaber: Diehl AKO Stiftung & Co. KG, 88239 Wangen (DE)
(72) Erfinder: Raunig, Bernd, 12279 Berlin (DE)
(74) Vertreter: Diehl Patentabteilung

(56) Entgegenhaltungen:
- EP-A- 0 262 909
- EP-A- 1 122 886
- EP-A- 1 198 063
- EP-A- 1 204 209

## Beschreibung

Die vorliegende Erfindung betrifft eine Schaltungsanordnung für einen kapazitiven Berührungsschalter.

In vielen elektrischen Geräten, insbesondere auch in Haushaltsgeräten wie Herden, Kochfeldern, Mikrowellenöfen, Spülmaschinen, Waschmaschinen und dergleichen, werden immer häufiger Berührungsschalter eingesetzt, die durch ein einfaches Berühren durch einen Benutzer einen bestimmten Schaltvorgang auslösen. Im Fall eines kapazitiven Berührungssensors bzw. -schalters weist die Sensorschaltung zum Beispiel ein Kondensator-Flächenelement auf, das zusammen mit dem Benutzer eine Kapazität bildet, die entsprechend dem Betätigen des kapazitiven Sensorelements, d.h. dem Berühren oder Nicht-Berühren des Kondensator-Flächenelements variabel ist. Die Veränderung der Kapazität des kapazitiven Sensorelements durch eine Berührung durch den Benutzer wirkt sich entsprechend auf ein Ausgangssignal der Sensorschaltung aus, was von einer angeschlossenen Auswerteschaltung entsprechend als eine Betätigung des kapazitiven Berührungsschalters ausgewertet wird.

Wie zum Beispiel aus den Dokumenten EP-A-1 204 209, EP-A-0 262 909, EP-A-1 122 886 und EP-B-1 198 063 bekannt, können derartige Schaltungsanordnungen für einen kapazitiven Berührungsschalter auch eine Sensorschaltung mit wenigstens einem Transistorbauteil aufweisen.

Der vorliegenden Erfindung liegt die Aufgabe zugrunde, eine weitere Schaltungsanordnung für einen kapazitiven Berührungsschalter bereitzustellen, die eine Sensorschaltung mit einem einfachen und zuverlässigen Aufbau enthält.

Diese Aufgabe wird durch eine Schaltungsanordnung mit den Merkmalen des Anspruchs 1 gelöst. Vorteilhafte Ausgestaltungen und Weiterbildungen der Erfindung sind Gegenstand der abhängigen Ansprüche.

Die Schaltungsanordnung für einen kapazitiven Berührungsschalter enthält eine Sensorschaltung mit einem kapazitiven Sensorelement, das bei Berührung seinen Kapazitätswert verändert, sowie eine Auswerteschaltung, der ein Ausgangssignal der Sensorschaltung zugeführt wird, um zu bestimmen, ob das kapazitive Sensorelement betätigt wird oder nicht. Die Sensorschaltung selbst weist auf: eine erste Spannungsquelle zum Liefern einer auf ein Bezugspotential bezogenen Betriebsspannung; einen ersten pnp-Transistor, dessen Basis über einen ersten Widerstand mit dem kapazitiven Sensorelement und über einen zweiten Widerstand mit der Betriebsspannung verbunden ist und dessen Emitter über einen dritten Widerstand mit der Betriebsspannung verbunden ist; eine zweite auf das Bezugspotential bezogene Spannungsquelle zum Liefern einer Pulsspannung, die an dem Kollektor des ersten pnp-Transistors anliegt; und einen zweiten pnp-Transistor, dessen Basis mit dem Emitter des ersten pnp-Transistors verbunden ist, dessen Kollektor mit dem Bezugspotential verbunden ist und dessen Emitter über eine Parallelschaltung aus einem vierten Widerstand und einer Kapazität mit der Betriebsspannung verbunden ist. Der Auswerteschaltung wird schließlich das Ausgangssignal zugeführt, das am Emitter des zweiten pnp-Transistors bezogen auf das Bezugspotential abgegriffen wird.

Auf der Basis dieser Grundschaltung lassen sich auch problemlos Schaltungsanordnungen mit mehreren parallel betriebenen Sensorschaltungen, mehreren zyklisch betriebenen Sensorschaltungen oder mehreren Sensorschaltungen im Matrixbetrieb aufbauen.

Obige sowie weitere Merkmale und Vorteile der Erfindung werden aus der nachfolgenden Beschreibung bevorzugter, nicht-einschränkender Ausführungsbeispiele unter Bezugnahme auf die beiliegenden Zeichnungen besser verständlich. Darin zeigen:
- Fig. 1: ein Blockschaltbild einer Schaltungsanordnung für einen kapazitiven Berührungsschalter gemäß einem ersten Ausführungsbeispiel der vorliegenden Erfindung;
- Fig. 2: ein Blockschaltbild einer Schaltungsanordnung für mehrere parallel betriebene kapazitive Berührungsschalter gemäß einem zweiten Ausführungsbeispiel der vorliegenden Erfindung;
- Fig. 3: ein Blockschaltbild einer Schaltungsanordnung für mehrere zyklisch betriebene kapazitive Berührungsschalter gemäß einem dritten Ausführungsbeispiel der vorliegenden Erfindung; und
- Fig. 4: ein Blockschaltbild einer Schaltungsanordnung für mehrere kapazitive Berührungsschalter im Matrixbetrieb gemäß einem vierten Ausführungsbeispiel der vorliegenden Erfindung.

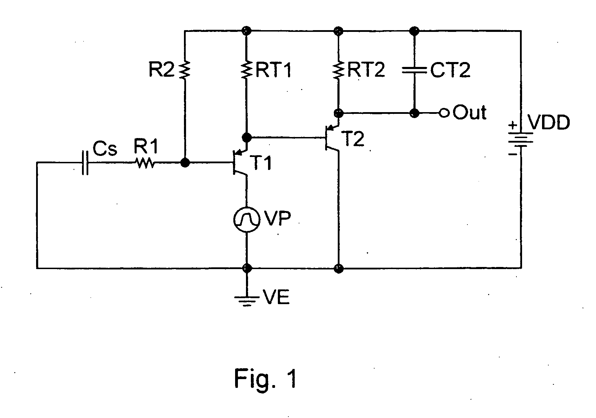

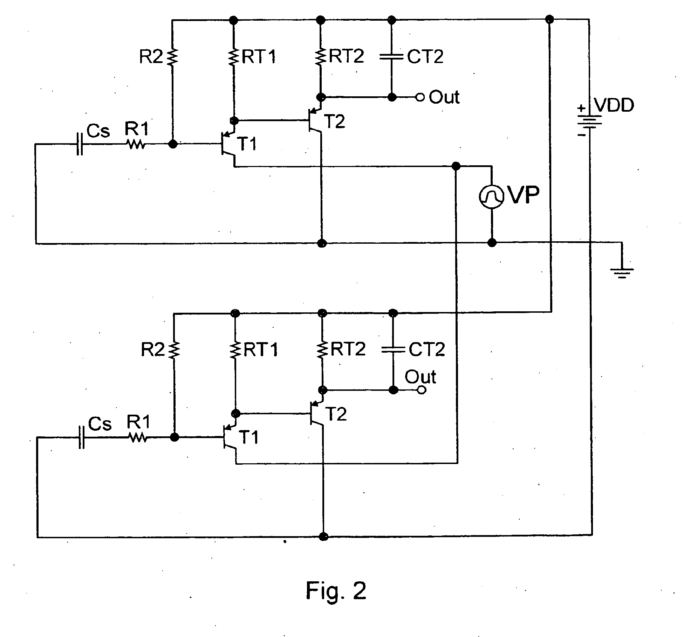

Fig. 1 zeigt den Aufbau einer Schaltungsanordnung für einen kapazitiven Berührungsschalter gemäß der Erfindung, der in elektrischen Geräten, insbesondere in elektrischen Haushaltsgeräten wie Herden, Kochfeldern, Mikrowellenöfen, Spülmaschinen, Waschmaschinen und dergleichen, einsetzbar ist. Unter Bezugnahme auf Fig. 2 bis 4 werden anschließend verschiedene Ausführungsbeispiele einer Schaltungsanordnung mit mehreren kapazitiven Berührungsschaltern beschrieben, die auf dem Aufbau der einfachen Schaltungsanordnung von Fig. 1 basieren.

Die Schaltungsanordnung für einen kapazitiven Berührungsschalter umfasst eine Sensorschaltung und eine Auswerteschaltung, wobei in den Figuren jeweils nur die Sensorschaltung dargestellt ist, deren Ausgangssignal Out der Auswerteschaltung zugeführt wird. Die Sensorschaltung enthält insbesondere ein kapazitives Sensorelement, zum Beispiel in Form eines Kondensator-Flächenelements, das zusammen mit einem Benutzer über ein Dieleketrikum als Teil einer Bedientafel des Haushaltsgeräts eine Kapazität Cs bildet. Diese Kapazität Cs des Sensorelements ist entsprechend dem Betätigen des kapazitiven Berührungsschalters, d.h. dem Berühren oder Nicht-Berühren des kapazitiven Sensorelements, variabel. Es sei an dieser Stelle aber ausdrücklich darauf hingewiesen, dass die vorliegende Erfindung nicht auf eine spezielle Art oder Anordnung des kapazitiven Sensorelements beschränkt ist.

Dieses kapazitive Sensorelement mit der Kapazität Cs ist über einen ersten Widerstand R1 mit der Basis eines ersten pnp-Transistors T1 verbunden. Die Basis des ersten pnp-Transistors T1 ist ferner über einen zweiten Widerstand R2 mit einer Betriebsspannung VDD verbunden, die von einer ersten Spannungsquelle zur Verfügung gestellt wird. Der Emitter des ersten pnp-Transistors T1 liegt über einen dritten Widerstand RT1 ebenfalls an der Betriebsspannung VDD.

Der Kollektor des ersten pnp-Transistors T1 ist mit einer Pulsspannung VP verbunden, die von einer zweiten Spannungsquelle, zum Beispiel in Form eines Ausgangspins eines Mikrocontrollers zur Verfügung gestellt wird.

Der Emitter des ersten pnp-Transistors T1 ist weiter mit der Basis eines zweiten pnp-Transistors T2 verbunden. Der Kollektor dieses zweiten pnp-Transistors T2 liegt auf der Bezugsspannung der Schaltungsanordnung, und der Emitter dieses zweiten pnp-Transistors T2 ist über eine Parallelschaltung aus einem vierten Widerstand RT2 und einer Kapazität CT2 mit der Betriebsspannung VDD verbunden.

Das Ausgangssignal Out der Sensorschaltung wird am Emitter des zweiten pnp-Transistors T2 abgegriffen und der Auswerteschaltung, d.h. zum Beispiel einem ADC-Eingang eines Mikrocontrollers zugeführt.

Die Bezugsspannung aller Schaltungsteile, und auch die Bezugspotentiale der Betriebsspannung VDD und der Pulsspannung VP sind bevorzugt mit dem Erdpotential VE verbunden.

Es folgt nun eine kurze Beschreibung der Funktionsweise dieser Schaltungsanordnung von Fig. 1.

Die Kapazität Cs des kapazitiven Sensorelements, die im Mittel auf die Betriebsspannung VDD aufgeladen ist, wird durch die Pulsspannung VP am Kollektor des ersten pnp-Transistors T1 fortlaufend durch die Differenz zwischen dem Strom durch den zweiten Widerstand R2 und dem Basisstrom des ersten pnp-Transistors T1 umgeladen. Mit steigendem Kapazitätswert Cs, d.h. beim Berühren des kapazitiven Sensorelements bzw. beim Betätigen des kapazitiven Berührungsschalters, wird das Tastverhältnis der den ersten pnp-Transistor T1 durchschaltenden Basisspannung kleiner. Als Folge davon wird auch der zweite pnp-Transistor T2 mit einem geringeren Tastverhältnis durchgeschaltet, was wiederum eine steigende Ausgangsspannung Out am Emitter des zweiten pnp-Transistors T2 zum Ergebnis hat. Diese Veränderung des Ausgangssignals Out der Sensorschaltung wird in der Auswerteschaltung erfasst und als ein Betätigen des kapazitiven Berührungsschalters ausgewertet.

Die Kollektor-Basis-Kapazität und die Basis-Emitter-Kapazität des ersten pnp-Transistors T1 sind für die dynamischen Vorgänge in der Schaltungsanordnung von Bedeutung. Sind der erste Widerstand R1 und die Kapazität Cs des Sensorelements nicht vorhanden, d.h. liegt keine Betätigung des kapazitiven Berührungsschalters vor, so erfolgt in Abhängigkeit von dem zweiten Widerstand R2 und der Kollektor-Basis-Kapazität und der Basis-Emitter-Kapazität des ersten pnp-Transistors T1 ein sich aufschaukelndes, teilweises Durchschalten des ersten pnp-Transistors T1. Das Durchschalten erfolgt immer dann, wenn die Pulsspannung VP gleich der Bezugsspannung VE ist. Dies bewirkt, dass der Spannungsabfall über dem dritten Widerstand RT1 periodisch in den Pausen der Pulsspannung VP bis zu einem Ausgleichswert ansteigt. Mit anderen Worten wird die Emitterspannung des ersten pnp-Transistors T1 periodisch mit den Pausen der Pulsspannung VP kleiner als die Betriebsspannung VDD, bis auf einen Gleichgewichtswert.

Über den zweiten pnp-Transistor T2 wird die Kapazität CT2 auf den Spitzenwert davon aufgeladen (abzüglich der Basis-Emitterspannung des zweiten pnp-Transistors T2). Das Anschalten der Kapazität Cs über den ersten Widerstand R1, d.h. ein Berühren des kapazitiven Sensorelements, verkleinert diesen Effekt. Je größer die Kapazität Cs wird, umso geringer wird der Einfluss der Kollektor-Basis-Kapazität und der Basis-Emitter-Kapazität des ersten pnp-Transistors T1 sowie des zweiten Widerstandes R2; die Kapazität Cs wird dann fast auf VDD aufgeladen und der erste pnp-Transistor T1 sperrt dauerhaft. Das heißt, die Spannung über dem dritten Widerstand RT1 wird annähernd zu 0 V, der zweite pnp-Transistor T2 sperrt, die Kapazität CT2 wird entladen und das Ausgangssignal entspricht dann etwa der Betriebsspannung VDD.

Bei einer konstanten Spannung VP = 0 V wäre die Kapazität Cs über den ersten und den zweiten Widerstand R1, R2 auf die Betriebsspannung VDD aufgeladen. Bei einer konstanten Spannung VP = VDD wäre die Kapazität Cs über den ersten und den zweiten Widerstand R1, R2 ebenfalls auf die Betriebsspannung VDD aufgeladen. Die Frequenz der Pulsspannung VP der zweiten Spannungsquelle muss daher hoch genug sein, um den oben beschriebenen dynamischen Effekt zu erzielen. Geeignet sind zum Beispiel eine Pulsbreite von etwa 10 µs und eine Periode von etwa 20 µs.

Der erste pnp-Transistor T1 ist gegenüber einer Schaltung einer einfachen Kapazität auf der Basis-Kollektor-Strecke und einer einfachen Kapazität auf der Basis-Emitter-Strecke vorteilhaft, da die Stromverstärkung des Transistors einen größeren Spannungsabfall über dem dritten Widerstand RT1 und damit einen größeren Wert des Ausgangssignals Out bewirkt.

Der erste Widerstand R1 dient als Vorwiderstand der Verbesserung der elektromagnetischen Verträglichkeit der Schaltungsanordnung.

Auf der Basis dieser Schaltungsanordnung für einen kapazitiven Berührungsschalter von Fig. 1 lassen sich auf einfache Weise Schaltungsanordnungen mit mehreren Sensorschaltungen aufbauen, falls die Schaltungsanordnung für mehrere kapazitive Berührungsschalter ausgelegt werden soll.

Fig. 2 zeigt als ersten solchen Fall eine Schaltungsanordnung für einen Parallelbetrieb von zwei oder mehr Sensorschaltungen mit jeweils einem kapazitiven Sensorelement.

Für den Parallelbetrieb der Sensorschaltungen sind die Kollektoren der ersten pnp-Transistoren T1 aller Sensorschaltungen mit einer gemeinsamen zweiten Spannungsquelle verbunden, welche die Pulsspannung VP liefert. Ebenso wird die Betriebsspannung VDD für alle Sensorschaltungen von einer gemeinsamen ersten Spannungsquelle geliefert. Die Ausgangssignale Out der mehreren Sensorschaltungen können gleichzeitig abgegriffen und parallel ausgewertet werden.

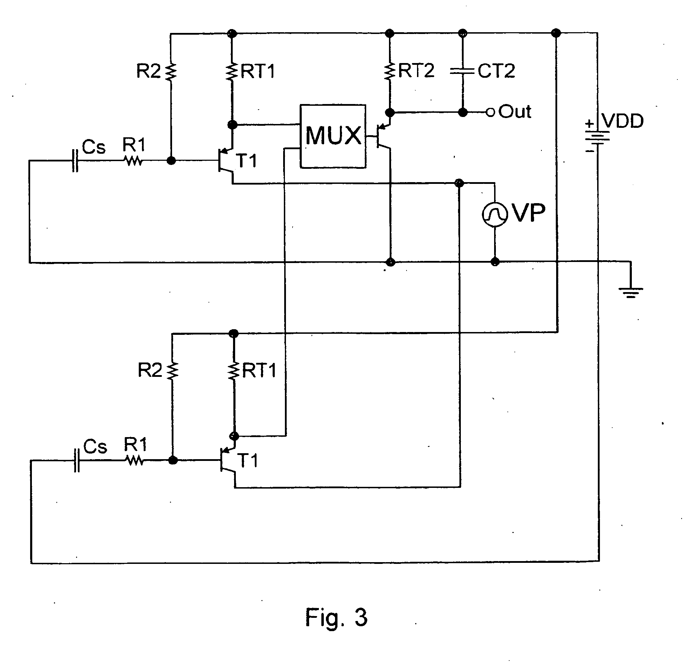

Wie in Fig. 3 veranschaulicht, ist auch ein zyklischer Betrieb von zwei oder mehr Sensorschaltungen mit jeweils einem kapazitiven Sensorelement möglich.

Die Kollektoren der ersten pnp-Transistoren T1 aller Sensorschaltungen sind wieder mit einer gemeinsamen zweiten Spannungsquelle für die Pulsspannung VP verbunden, und die Betriebsspannung VDD wird für alle Sensorschaltungen von einer gemeinsamen ersten Spannungsquelle geliefert. Die Emitter der ersten pnp-Transistoren T1 aller Sensorschaltungen sind mit den Eingängen eines bekannten Analogschalter-Multiplexers MUX verbunden, dessen Ausgang mit der Basis eines gemeinsamen zweiten pnp-Transistors T2 verbunden ist. Die Emitter der ersten pnp-Transistoren T1 werden somit durch den Multiplexer MUX zyklisch auf die Basis des zweiten pnp-Transistors T2 durchgeschaltet.

Der gemeinsame zweite pnp-Transistor T2 ist über die Parallelschaltung eines gemeinsamen vierten Widerstandes RT2 und einer Kapazität CT2 mit der Betriebsspannung VDD verbunden. Diese Schaltungsanordnung für den Multiplexbetrieb von mehreren Sensorschaltungen benötigt somit nur einen zweiten pnp-Transistor T2, nur einen vierten Widerstand RT2 und nur eine Kapazität CT2.

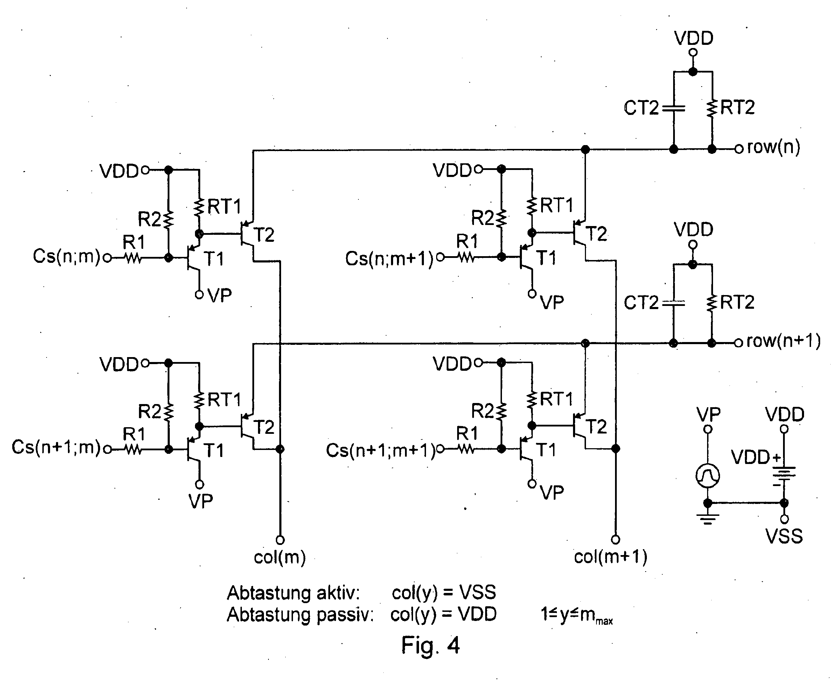

Neben dem Parallelbetrieb und dem Multiplexbetrieb von mehreren Sensorschaltungen, d.h. von mehreren kapazitiven Berührungsschaltern, ist auch ein Matrixbetrieb möglich, wie dies anhand von Fig. 4 näher erläutert wird.

Die Modifikation der Schaltungsanordnung besteht darin, dass die Parallelschaltung aus viertem Widerstand RT2 und Kapazität CT2 für alle Sensorschaltungen einer Zeile row(x) gemeinsam genutzt wird. Mit anderen Worten sind die Emitter der zweiten pnp-Transistoren T2 aller Sensorschaltungen einer Matrixzeile row(x) mit einer gemeinsamen Parallelschaltung eines vierten Widerstandes RT2 und einer Kapazität CT2 verbunden.

Über die Kollektoren der zweiten pnp-Transistoren T2 werden diese spaltenweise deaktiviert oder aktiviert, je nachdem, ob einerseits die Betriebsspannung VDD oder alle Spannung abgeschaltet, d.h. die Kollektoren freigeschaltet (tristate mode) werden oder andererseits eine Spannung VSS an einer Auswahl-Spaltenleitung anliegt. Die Auswahl-Spaltenleitungen col(y) können bekanntermaßen einzeln in einer vorgegebenen Reihenfolge aktiviert werden. Die Zeilenleitungen row(x) tragen dann parallel die von den jeweiligen Sensorschaltungen abgegriffenen und aufbereiteten Ausgangsspannungen Out, die der Auswerteschaltung parallel oder im Multiplexbetrieb zugeführt werden.

## Patentansprüche

1. Schaltungsanordnung für einen kapazitiven Berührungsschalter, mit
einer Sensorschaltung mit einem kapazitiven Sensorelement, das bei Berührung seinen Kapazitätswert (Cs) verändert; und
einer Auswerteschaltung, der ein Ausgangssignal (Out) der Sensorschaltung zugeführt wird, zum Bestimmen, ob das kapazitive Sensorelement betätigt wird oder nicht,
wobei die Sensorschaltung aufweist:
eine erste Spannungsquelle zum Liefern einer auf ein Bezugspotential (V_{E}) bezogenen Betriebsspannung (VDD);
einen ersten pnp-Transistor (T1), dessen Basis über einen ersten Widerstand (R1) mit dem kapazitiven Sensorelement und über einen zweiten Widerstand (R2) mit der Betriebsspannung (VDD) verbunden ist und dessen Emitter über einen dritten Widerstand (RT1) mit der Betriebsspannung (VDD) verbunden ist;
eine zweite Spannungsquelle zum Liefern einer auf das Bezugspotential (V_{E}) bezogenen Pulsspannung (VP), die an dem Kollektor des ersten pnp-Transistors (T1) anliegt; und
einen zweiten pnp-Transistor (T2), dessen Basis mit dem Emitter des ersten pnp-Transistors (T1) verbunden ist, dessen Kollektor mit dem Bezugspotential (VE) verbunden ist und dessen Emitter über eine Parallelschaltung aus einem vierten Widerstand (RT2) und einer Kapazität (CT2) mit der Betriebsspannung (VDD) verbunden ist; und
das Ausgangssignal (Out) am Emitter des zweiten pnp-Transistors (T2) bezogen auf das Bezugspotential (V_{E}) abgegriffen wird.

2. Schaltungsanordnung nach Anspruch 1,
**dadurch gekennzeichnet,**
**dass** die Schaltungsanordnung mehrere Sensorschaltungen mit jeweils einem kapazitiven Sensorelement enthält, die parallel betrieben werden, wobei eine gemeinsame erste Spannungsquelle und eine gemeinsame zweite Spannungsquelle verwendet werden.

3. Schaltungsanordnung nach Anspruch 1,
**dadurch gekennzeichnet,**
**dass** die Schaltungsanordnung mehrere Sensorschaltungen mit jeweils einem kapazitiven Sensorelement enthält, die zyklisch betrieben werden,
wobei eine gemeinsame erste Spannungsquelle, eine gemeinsame zweite Spannungsquelle, ein gemeinsamer zweiter Transistor (T2), ein gemeinsamer vierter Widerstand (RT2) und eine gemeinsame Kapazität (CT2) verwendet werden, und
wobei ein Multiplexer (MUX) zwischen die Emitter der ersten Transistoren (T1) der mehreren Sensorschaltungen und die Basis des gemeinsamen zweiten Transistors (T2) geschaltet ist.

4. Schaltungsanordnung nach Anspruch 1**,**
**dadurch gekennzeichnet,**
**dass** die Schaltungsanordnung mehrere Sensorschaltungen mit jeweils einem kapazitiven Sensorelement im Matrixbetrieb enthält,
wobei die Emitter aller zweiten Transistoren (T2) einer Matrixzeile über eine gemeinsame Parallelschaltung des dritten Widerstandes (RT2) und der Kapazität (CT2) mit der Betriebsspannung (VDD) verbunden und die Kollektoren jeweils eines zweiten Transistors (T2) einer Matrixzeile über alle Matrixzeilen zu einer Matrixspalte zusammengeschaltet sind.

## Claims

1. Circuit arrangement for a capacitive touch switch, having
a sensor circuit with a capacitive sensor element which changes its capacitance value (Cs) when touched; and
an evaluation circuit which is supplied with an output signal (Out) from the sensor circuit in order to determine whether or not the capacitive sensor element is actuated,
the sensor circuit having:
a first voltage source for providing an operating voltage (VDD) which is based on a reference potential (V_{E});
a first pnp transistor (T1), the base of which is connected to the capacitive sensor element via a first resistor (R1) and to the operating voltage (VDD) via a second resistor (R2), and
the emitter of which is connected to the operating voltage (VDD) via a third resistor (RT1);
a second voltage source for providing a pulse voltage (VP) which is based on the reference potential (V_{E}) and is applied to the collector of the first pnp transistor (T1); and
a second pnp transistor (T2), the base of which is connected to the emitter of the first pnp transistor (T1), the collector of which is connected to the reference potential (VE), and the emitter of which is connected to the operating voltage (VDD) via a parallel circuit comprising a fourth resistor (RT2) and a capacitance (CT2); and
the output signal (Out) being tapped off at the emitter of the second pnp transistor (T2) on the basis of the reference potential (V_{E}).

2. Circuit arrangement according to Claim 1,
**characterized in that**
the circuit arrangement contains a plurality of sensor circuits each with a capacitive sensor element which are operated in a parallel manner, a common first voltage source and a common second voltage source being used.

3. Circuit arrangement according to Claim 1,
**characterized in that**
the circuit arrangement contains a plurality of sensor circuits each with a capacitive sensor element which are operated in a cyclical manner,
a common first voltage source, a common second voltage source, a common second transistor (T2), a common fourth resistor (RT2) and a common capacitance (CT2) being used, and
a multiplexer (MUX) being connected between the emitters of the first transistors (T1) of the plurality of sensor circuits and the base of the common second transistor (T2).

4. Circuit arrangement according to Claim 1,
**characterized in that**
the circuit arrangement contains a plurality of sensor circuits each with a capacitive sensor element in matrix operation,
the emitters of all second transistors (T2) in a matrix row being connected to the operating voltage (VDD) via a common parallel circuit comprising the third resistor (RT2) and the capacitance (CT2), and the collectors of each second transistor (T2) in a matrix row being interconnected over all matrix rows to form a matrix column.

## Revendications

1. Arrangement de circuit pour un détecteur de contact capacitif, comprenant
un circuit de détection muni d'un élément de détection capacitif qui modifie la valeur de sa capacité (Cs) en cas de contact, et
un circuit d'interprétation auquel est acheminé un signal de sortie (Out) du circuit de détection afin de déterminer si l'élément de détection capacitif est actionné ou non,
le circuit de détection présentant :
une première source de tension pour délivrer une tension de service (VDD) rapportée à un potentiel de référence (V_{E}) ;
un premier transistor PNP (T1) dont la base est reliée avec l'élément de détection capacitif par le biais d'une première résistance (R1) et avec la tension de service (VDD) par le biais d'une deuxième résistance (R2) et dont l'émetteur est relié avec la tension de service (VDD) par le biais d'une troisième résistance (RT1) ;
une deuxième source de tension pour délivrer une tension impulsionnelle (VP) rapportée au potentiel de référence (V_{E}), laquelle est appliquée au collecteur du premier transistor PNP (T1) ; et
un deuxième transistor PNP (T2) dont la base est reliée avec l'émetteur du premier transistor PNP (T1), dont le collecteur est relié avec le potentiel de référence (V_{E}) et dont l'émetteur est relié avec la tension de service (VDD) par le biais d'un circuit parallèle composé d'une quatrième résistance (RT2) et d'un condensateur (CT2) ; et
le signal de sortie (Out) est prélevé sur l'émetteur du deuxième transistor PNP (T2) par rapport au potentiel de référence (V_{E}) .

2. Arrangement de circuit selon la revendication 1, **caractérisé en ce que** l'arrangement de circuit contient plusieurs circuits de détection comprenant chacun un élément de détection capacitif et qui fonctionnent en parallèle, une première source de tension commune et une deuxième source de tension commune étant utilisées.

3. Arrangement de circuit selon la revendication 1, **caractérisé en ce que** l'arrangement de circuit contient plusieurs circuits de détection comprenant chacun un élément de détection capacitif et qui fonctionnent de manière cyclique,
une première source de tension commune, une deuxième source de tension commune, un deuxième transistor (T2) commun, une quatrième résistance (RT2) commune et un condensateur (CT2) commun étant utilisés et
un multiplexeur (MUX) étant branché entre l'émetteur des premiers transistors (T1) des plusieurs circuits de détection et la base du deuxième transistor (T2) commun .

4. Arrangement de circuit selon la revendication 1, **caractérisé en ce que** l'arrangement de circuit contient plusieurs circuits de détection comprenant chacun un élément de détection capacitif en mode matriciel,
l'émetteur de tous les deuxièmes transistors (T2) d'une ligne de la matrice étant relié avec la tension de service (VDD) par le biais d'un branchement en parallèle commun de la troisième résistance (RT2) et du condensateur (CT2) et les collecteurs d'un deuxième transistor (T2) respectif d'une ligne de la matrice étant interconnectés sur toutes les lignes de la matrice pour former une colonne de matrice.
